# EUROPEAN PATENT APPLICATION

(11) **EP 2 698 805 A1**
(43) Date of publication of application: **19.02.2014**
(21) Application number: 12180595.6
(22) Date of filing: 16.08.2012
(51) Int. Cl.: H01J 37/28, H01J 37/244, H01J 37/256

(54) **Method of performing EDX in a charged-particle microscope**

(71) Applicant: FEI Company, Hillsboro, OR 97124-5793 (US)
(72) Inventor: Owen, Michael, Geebung, Queensland 4034 (AU); Sullivan, Matt, Holland Park West, Queensland 4121 (AU)
(74) Representative: Bakker, Hendrik

(57) **Abstract**

A method of automatically examining a sample using a charged-particle microscope, comprising the following steps:
- Providing the sample on a sample holder;
- Selecting a set S of locations on the sample;
- For each location in S:
■ Directing a focused input beam of charged particles onto that location, thereby producing an interaction that causes a flux of emitted radiation to emanate from that location;
■ Detecting X-rays in said flux using a multi-channel photon-counting detector, thus accruing an X-ray spectrum for said location during a given counting time,

thereby acquiring a matrix of X-ray spectra for the set S,
which method comprises the following steps:
- Prior to acquiring said matrix of X-ray spectra, selecting a set T of positions on the sample, whereby T is as least a subset of S, and, for each position in T:
■ Directing said focused input beam of charged particles onto that position;
■ Performing a measurement operation that comprises at least one of the following procedures:
□ Accruing an X-ray spectrum for said position during a test counting time shorter than said given counting time;
□ Detecting electrons in said flux using an electron detector and determining an electron brightness for said position;

- Analyzing the data obtained in said measurement operations and processing it to calculate a value of an input beam parameter selected from the group comprising beam current and beam energy;
- Using said calculated input beam parameter value in acquiring said matrix of X-ray spectra for the set S.

## Description

The invention relates to a method of automatically examining a sample using a charged-particle microscope, comprising the following steps:
- Providing the sample on a sample holder;
- Selecting a set S of locations on the sample;
- For each location in S:
   ■ Directing a focused input beam of charged particles onto that location, thereby producing an interaction that causes a flux of emitted radiation to emanate from that location;
   ■ Detecting X-rays in said flux using a multi-channel photon-counting detector, thus accruing an X-ray spectrum for said location during a given counting time,
   thereby acquiring a matrix of X-ray spectra for the set S.

The invention also relates to a charged-particle microscope suitable for performing such a method.

For purposes of clarity and consistency, the following terms as used throughout this text and the appended claims should be interpreted as follows:
- The term "charged particle" refers to an electron or ion (generally a positive ion, such as a Gallium ion or Helium ion, for example).
- The term "microscope" refers to an apparatus that is used to create a magnified image of an object, feature or component that is generally too small to be seen in satisfactory detail with the naked human eye. In addition to having an imaging functionality, such an apparatus may also have a machining functionality; for example, it may be used to locally modify a sample by removing matter therefrom ("milling" or "ablation") or adding matter thereto ("deposition"). Said imaging functionality and machining functionality may be provided by the same type of charged particle, or may be provided by different types of charged particle; for example, a Focused Ion Beam (FIB) microscope may employ a (focused) ion beam for machining purposes and an electron beam for imaging purposes (a so-called "dual beam" microscope, or "FIB-SEM"), or it may perform machining with a relatively high-energy ion beam and perform imaging with a relatively low-energy ion beam. On the basis of this interpretation, tools such as the following should be regarded as falling within the scope of the current invention: electron microscopes, FIB apparatus, EBID and IBID apparatus (EBID = Electron-Beam-Induced Deposition; IBID = lon-Beam-Induced Deposition), etc.

- A focused beam is considered to be a beam having a confined cross-sectional area that is relatively small compared to the sample under investigation; in this way, it is possible to confine the beam's impingement footprint to relatively small sub-regions of the sample. The beam may be converging or collimated in nature.
- A multi-channel detector is considered to be a detector that can sort an incoming flux of photonic radiation into multiple energy channels, each representing a given energy range.

In what follows, the invention will - by way of example - often be set forth in the specific context of electron microscopes. However, such simplification is intended solely for clarity/illustrative purposes, and should not be interpreted as limiting.

Electron microscopy is a well-known technique for imaging microscopic objects.

The basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" beam of ions, allowing supportive activities such as ion-beam milling or ion-beam-induced deposition, for example. In traditional electron microscopes, the imaging beam is "on" for an extended period of time during a given imaging session; however, electron microscopes are also available in which imaging occurs on the basis of a relatively short "flash" or "burst" of electrons, such an approach being of potential benefit when attempting to image moving samples or radiation-sensitive specimens, for example.

When a beam of particulate radiation (such as an electron beam or ion beam) impinges on a sample, it generally interacts with the sample in a manner that causes different types of emitted radiation to emanate from the sample. Such emitted radiation may, for example, comprise Secondary Electrons (SEs), Backscatter Electrons (BSEs), visible/infrared/ultraviolet light (fluorescence and cathodoluminescence) and X-rays. Of these radiation types, electrons are relatively easy and cheap to detect, e.g. using a photo-multiplier (PM) in conjunction with a scintillator [whereby it should be noted that the employed PM may be based on an evacuated vitreous tube design with dynodes, or may instead employ a solid-state semiconductor-based detector (e.g. as in the case of so-called Multi-Pixel Photon Counters, also referred to as SSPMs (Solid State Photo-Multipliers))]. The detection of visible/infrared/ultraviolet light is also relatively straightforward, and can again be performed using a PM (without scintillator) or a photodiode cell, for example. On the other hand, X-ray detectors generally tend to be relatively expensive and slow, and typically offer a relatively limited field of view, but they are conventionally of great use in performing compositional analyses of samples, such as in the case of so-called EDX (Energy Dispersive X-ray) detectors, for example.

EDX (also often referred to as EDS) is a method of the type described in the opening paragraph. In this technique, a sample (often, but not necessarily, mineralogical in nature) is bombarded with a focused input beam of charged particles, e.g. in a Scanning Electron Microscope. A lower-shell electron in an atom of the sample can be ejected from its orbit by a collision with one of these bombarding particles, creating an electron hole that is promptly filled by the de-excitation of a higher-shell electron in the atom in question, with the concurrent release of a quantum of energy in the form of an X-ray photon. The energy signature/distribution of photons emitted in this way will be characteristic of the particular electron shell structure of the atom in question, and can thus be used as a "fingerprint" in performing compositional analysis of the sample. An energy-dispersive spectrometric detector collects, sorts and counts the different photons of different energies, producing a measured spectrum for the location of the sample onto which the focused input beam was directed; such a spectrum can be rendered as a graph of counts per channel (ordinate) versus channel number (abscissa), corresponding to intensity versus energy, and generally comprising various peaks - whose energy can be used to identify the generating material (which may be an element, chemical compound or mineral, for example, and which may be amorphous or crystalline in nature, for example) and whose height can (in principle) be used to estimate relative quantity of the generating material. One then automatically moves the sample and/or the beam so that the beam is directed onto a new location on the sample, and automatically repeats the process described above at said new location. This technique is particularly useful in the field of mineralogy, in which a small sample may contain many different kinds of minerals; however, its usefulness in fields such as metallurgy, microbiology and semiconductor science is also self-evident. For more information on EDX, reference is made to the following webpage:
http://en.wikipedia.org/wiki/Energy Dispersive Spectroscopy

Useful as it is, this known technique does, however, suffer from certain setbacks. For example:
(i) One problem lies in the nature of the exploited physical process (ejection and de-excitation of bound electrons), and is caused by the fact that not all materials demonstrate the same "brightness" as regards the production of a photon via this mechanism. As a result, assuming a fixed counting time (accumulation time) during a measurement session, significantly different photon count numbers can be accrued for different materials in a sample. Even for a single material, an emission spectrum will typically comprise multiple peaks of different heights - some of which may be so high as to dominate the spectrum, while others may be little more than a slight bump in the obtained data. However, when counting photons from several materials of significantly different brightnesses, the difference in magnitude between the highest and the lowest peaks can be even greater. Such a wide range of peak heights can cause smaller peaks to be missed/overlooked in background noise, unless the counting time is significantly increased; however, increasing the counting time in this manner necessarily incurs a significant throughput penalty, which is typically undesirable.
(ii) Another problem lies in the *modus operandi* of the employed detector, which sorts photons into different "channels" according to their perceived energy, and counts the number of photons in each channel within the allotted counting time. This sorting process is serial in nature, and can be thrown into confusion when the detector is confronted with the arrival of two consecutive photons in rapid temporal succession (an event conventionally referred to as a "pile-up"). Assuming these photons to have energies E₁ and E₂, respectively, the processing circuitry employed by the detector may be unsure as to whether it has just "seen" two distinct photons or a single photon of energy E₁ + E₂, since the temporal separation of the photons is not sufficiently large to allow an inflection point between them to be confidently distinguished from noise effects. To avoid "spoiling" accrued data, such pile-up events are conventionally discarded by said processing circuitry. In measurement scenarios involving relatively high fluxes of emitted X-ray radiation emanating from the sample, much potentially useful data may have to be discarded in this manner, so that measurement quality will inevitably suffer. It is somewhat ironic that, despite the high X-ray flux, there may be relatively little useful data for the employed detector, as a result of which the obtained spectrum may be noisy and relatively low-resolution, and its peak height(s) can no longer be reliably used to estimate the relative quantity of the material(s) generating the peak(s) in question. It should be noted that pile-up occurrence is a statistical effect that can happen at any time, even for relatively low levels of stimulated photonic flux; this is the reason why it is generally only labeled as being "significant" when the number of pile-ups at a particular location exceeds a preselected (discretionary) threshold. This threshold is - for many commonly available detectors - adjustable. However, there is generally a trade-off between registration time and registration accuracy (energy resolution) in an EDX detector: choosing a shorter registration time (so as to decrease the chance of pile-ups) will produce an attendant decrease in the certainty with which the energy of a registered photon can be measured, and *vice versa.*
(iii) Problems (i) and (ii) tend to exacerbate one another. For example, consider a material having high brightness, as alluded to in (i). A high X-ray flux produced by this material may "overwhelm" the processing circuitry of the employed detector, causing a drastic reduction in detection efficiency due to recurring pile-ups. This reduction, in turn, makes it even harder to effectively detect (weaker) spectral peaks due to materials with a lower brightness.

As a result of these effects, for a given counting time and fixed beam parameters (such as beam current and beam energy), when a matrix of X-ray spectra is automatically acquired at a set S of locations on a general, multi-material sample (e.g. as in automated mineralogy or metallurgy scans), the detected brightness at a given location may be so high as to cause pile-ups, or much too low to give an acceptable signal-to-noise ratio. Ideally, an EDX tool user in such circumstances would like to choose beam parameter values that produce a flux of X-ray radiation that is concurrently:
- Low enough to ensure that there is no significant pile-up behavior at any location;
- High enough to ensure the best attainable signal-to-noise ratio across the sample.

In other words, one would ideally like to achieve the highest possible X-ray flux level that does not cause (significant) pile-up behavior.

It is an object of the invention to address these issues. More specifically, it is an object of the invention to provide an X-ray spectroscopy method that can more effectively cope with the concurrent occurrence in a sample of materials having substantially discrepant X-ray brightnesses. In particular, it is an object of the invention that such a method should allow X-ray spectroscopy to be performed at an optimal X-ray flux level.

These and other objects are achieved in a method as specified in the opening paragraph, characterized by the following steps:
- Prior to acquiring said matrix of X-ray spectra, selecting a set T of positions on the sample, whereby T is as least a subset of S, and, for each position in T:
   ■ Directing said focused input beam of charged particles onto that position;
   ■ Performing a measurement operation that comprises at least one of the following procedures:
      □ Accruing an X-ray spectrum for said position during a test counting time shorter than said given counting time;
      □ Detecting electrons in said flux using an electron detector and determining an electron brightness for said position;
- Analyzing the data obtained in said measurement operations and processing it to calculate a value of an input beam parameter selected from the group comprising beam current and beam energy;
- Using said calculated input beam parameter value in acquiring said matrix of X-ray spectra for the set S.

In research leading to the invention, the inventors realized that, in principle, one way to solve the problems elucidated above would be using an iterative approach, whereby, for example:
(a) Using beam current value Iₙ, one acquires a matrix Mₙ of X-ray spectra for a sample during an automated "scan" of locations in the set S;
(b) If (significant) pile-up behavior is observed at one or more locations in Mₙ, then one adjusts Iₙ to a lower value Iₙ₊₁ and repeats step (a) at this new beam parameter value;
(c) On the other hand, if no (significant) pile-up behavior is observed in Mₙ, then one adjusts Iₙ to a higher value Iₙ₊₁ and repeats step (a) at this new beam parameter value, and so forth for iterations n+2, n+3, etc. However, such an approach has a number of major drawbacks, such as:
   - Throughput penalty: it takes quite a long time to acquire a single matrix of X-ray spectra, not to mind having to repeat this process in multiple iterations.
   - Radiation damage: bombarding a sample with charged particles tends to produce radiation damage, which will become progressively worse if multiple irradiation sessions are employed.

The inventors thus sought a more creative, faster, less damaging approach. They ultimately arrived at the insight that it would be very useful if one could use the results of a relatively fast "pre-scan" of the sample to intelligently pre-set an optimal value of a chosen input beam parameter (such as beam current) before starting acquisition of a matrix of X-ray spectra for the sample in question. Such a pre-scan might entail one (or both) of the following:
(I) Acquiring an "image" of at least part of the sample (some or all of the locations in the set S) based on detection of Backscatter Electrons (BSEs) in the flux emanating from the sample. BSE detectors are relatively fast, and BSEs are generally emitted at intensity levels that are easily registered; consequently, a BSE imaging scan of the sample is typically readily achievable. A BSE image is, in fact, a two-dimensional representation of measured BSE intensity as a function of coordinate position on the sample, and the inventors have found that the brightest BSE position in such an image can be used as a calibration/reference point in choosing the beam parameters (e.g. beam current) that can best be used during subsequent EDX measurements. This may be achieved in various ways. For example:
   - By consulting previously obtained data. In such a scenario, a log is kept of old BSE data and the corresponding EDX data. More particularly, a table is drawn up of the electron brightness at the brightest position in a BSE image versus optimal input beam parameter (such as beam current) for EDX analysis of that same position (giving optimal X-ray brightness without significant pile-up behavior). Such optimal input beam parameter values may have been obtained using an iterative approach (a)-(c) as set forth above, or another approach (such as the method of the current invention, for example). Where necessary, interpolation and/or extrapolation may be used to deduce values not explicitly contained in such a table. In addition or as an alternative, the data underlying such a table may be rendered in the form of a graphical / functional dependence - which may facilitate (automated) reference thereto.
   - By modeling the dependence between BSE brightness and EDX brightness, for one or more materials, in conjunction with calibration measurements. For example, on the basis of a data table (of the type referred to above) acquired for a given material, one might be able to derive a corresponding data table for a different material, based on a physical/chemical model.
(II) Alternatively (or additionally), said pre-scan could entail a fast (and relatively crude) EDX matrix acquisition using a relatively low counting time. Such a pre-scan would tend to be slower than a BSE imaging scan, but would be faster than a "proper" EDX matrix acquisition using a longer counting time. The component spectra accrued in this pre-scan would be relatively noisy, but would be sufficient to determine whether the beam parameters (e.g. beam current) used during the scan needed to be adjusted so as to achieve a more optimal result (in terms of maximum signal without pile-up behavior). An approach such as this may be facilitated by making use of reference/calibration data. For example, one could acquire a table/graph of optimal input beam current versus X-ray brightness for a reference material such as gold (which basically demonstrates maximal X-ray brightness), and used this to distill an optimal input beam current from the fast EDX pre-scan referred to here.

It deserves mention that, in many cases, previous analyses of similar (or identical) samples will already have yielded some qualitative information as to the types of materials present in a given (class of) sample; such information may not necessarily include applicable data as to the quantity and/or positional distribution of such materials, but it can nevertheless be of potential use in the context of the prior data (old data, reference data) alluded to in points (I) and (II) above.

It should be noted that the set S referred to in this document need not encompass the entire sample; it may instead be limited to just a portion of the sample. In fact, a particular sample may contain several such sets - S₁, S₂, etc. - each of which can best undergo EDX analysis at its own optimal beam parameter value. It should also be noted that the set T referred to here may or may not be equal to S; for example, it may be a subset of S containing "representative" positions distributed throughout S. The skilled artisan will readily understand these points.

As set forth above, the flux of X-ray radiation analyzed by an EDX detector is generated by ejective interaction of the input beam of radiation with bound electrons in atoms of the sample. The input beam parameter adjusted in the present invention in order to control the magnitude of this flux does so by adjusting the reaction cross-section for said ejective interaction. This can, for example, be achieved in the following ways:
- Adjusting the number of incoming particles in the input beam per unit of time, i.e. adjusting the beam *current.* In the case of a Schottky emitter (or other source, such as a thermionic gun) used to produce electrons, beam current adjustment can, for example, be achieved by locating one or more condenser lenses and a diaphragm in the path of the electron beam, and using the condenser lens(es) to vary the diameter of the beam impinging upon the diaphragm; this correspondingly varies the current in the beam downstream of the diaphragm.

- Adjusting the *energy* of individual particles in the incoming beam, which will influence the quantum efficiency of the ejective interaction. This can be achieved by adjusting the magnitude of an electrical potential used to accelerate the beam, for example.
- Adjusting the (effective) beam *cross-section,* e.g. using a diaphragm, or by varying the angle of incidence of the beam on the sample.

In the case of EDX, the inventors have found that beam current in particular lends itself to adjustment in the context of the present invention.

The invention will now be elucidated in more detail on the basis of exemplary embodiments and the accompanying schematic drawings, in which:
Figure 1 renders a longitudinal cross-sectional view of aspects of a charged-particle microscope (in this case a SEM) with which the method according to the current invention can be performed.
Figure 2 shows an example of an EDX spectrum obtained for a particular metallurgical sample.
Figure 3 shows a collection of three EDX spectra for Molybdenum, accrued at different measurement settings (beam current, counting (accumulation) time, registration time).

In the Figures, where relevant, corresponding parts are indicated using corresponding reference symbols.

### Embodiment 1

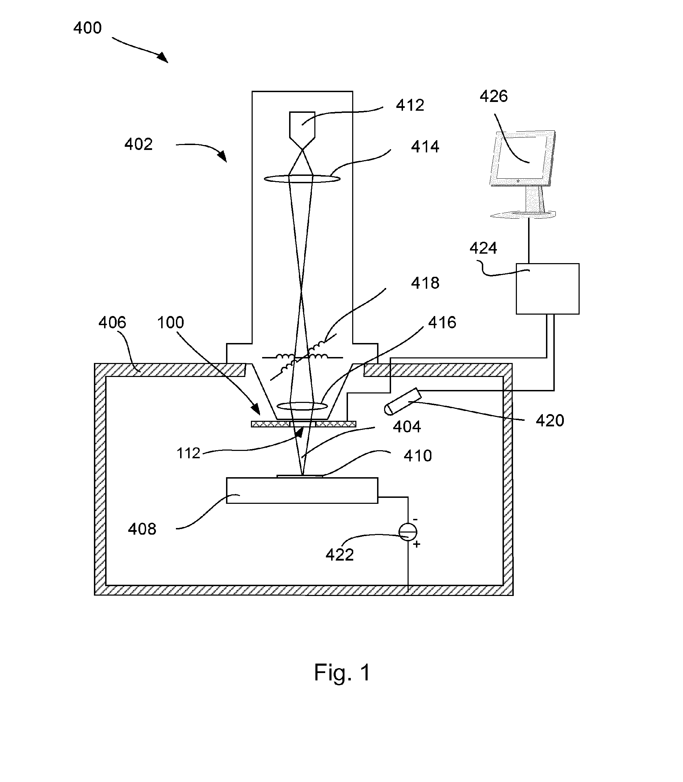

Figure 1 shows a charged-particle microscope 400, which, in this case, is a SEM. The microscope 400 comprises a particle-optical column 402, which produces a charged-particle beam 404 (in this case, an electron beam). The particle-optical column 402 is mounted on a vacuum chamber 406, which comprises a sample holder / stage 408 for holding a sample 410. The vacuum chamber 406 is evacuated using vacuum pumps (not depicted). With the aid of voltage source 422, the sample holder 408, or at least the sample 410, may be biased (floated) to an electrical potential with respect to ground.

The particle-optical column 402 comprises an electron source 412, a compound lens system 414, 416 to focus the electron beam 404 onto the sample 410, and a deflection unit 418. As regards detectors, the apparatus is equipped with:
- A first detector 420, for detecting a flux of X-rays emanating from the sample 410 in response to irradiation by the beam 404. In the present example, the detector 420 is a multi-channel photon-counting EDX detector.
- A second detector 100, for detecting a different type of emitted radiation emanating from the sample 410 in response to irradiation by the beam 404. In the present example, the detector 100 is a segmented electron detector, which can be used to detect backscatter electrons / secondary electrons, for example.

As here depicted, the apparatus uses both of these detector types; however, this is purely a design/implementation choice and, if desired, it's also possible to use just one of these detector types. The apparatus further comprises a computer processing apparatus (controller) 424 for controlling *inter alia* the deflection unit 418, lenses 414/416, and detectors 420,100, and displaying information gathered from the detectors 420,100 on a display unit 426.

By scanning the beam 404 over the sample 410, emitted radiation - comprising, for example, X-rays, infrared/visible/ultraviolet light, secondary electrons and backscatter (BSEs) - emanates from the sample 410. As the emitted radiation is position-sensitive (due to said scanning motion), the information obtained from the detectors 420, 100, will also be position-dependent. The signals from the detectors 420,100 are processed by the processing apparatus 424, and displayed on display unit 426. Such processing may include operations such as combining, integrating, subtracting, false colouring, edge enhancing, and other processing known to the person skilled in the art. In addition, automated recognition processes, e.g. as used for particle analysis, may be included in such processing.

It should be noted that many refinements and alternatives of such a set-up will be known to the skilled artisan, including, but not limited to, the detection of (infrared/visible/ultraviolet) light emanating from the sample 410, the use of dual beams (for example an electron beam 404 for imaging and an ion beam for machining (or, in some cases, imaging) the sample 410), the use of a controlled environment at the sample 410 (for example, maintaining a pressure of several mbar- as used in a so-called Environmental SEM - or by admitting gasses, such as etching or precursor gasses), etc.

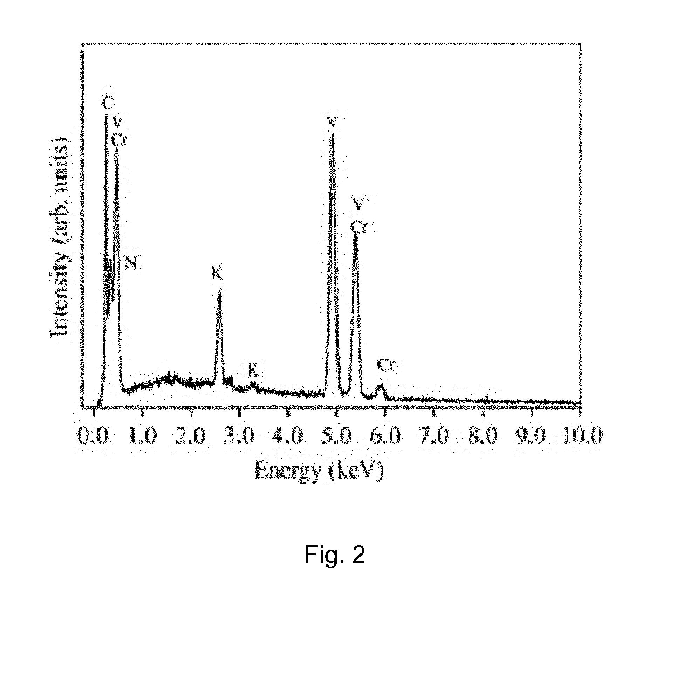

The depicted microscope 400 can used to accrue EDX spectra as follows:
- The sample 410 is positioned with respect to the (non-depicted) optical axis of the beam 404 by moving the sample holder 408 and/or the beam 404. Such movement is effected so as to place a particular location of the sample 410 in the path of the beam 404;
- When the beam 404 impinges on said location of the sample, it will generate (*inter alia*) a flux of X-rays as set forth above. This flux will comprise a stream of X-ray photons of (typically) various energies. Part of this flux impinges on a detection aperture of detector 420, which comprises a photoelectric converter. This converter generates a shower of electrons in response to registration of an X-ray photon, and this shower of electrons can then be processed by processing circuitry associated with the detector 420. Such circuitry may be within/on the detector and/or external thereto;
- The detector 420 (together with its associated processing circuitry) is a so-called multi-channel detector, in that it is able to sort registered X-ray photons according to energy (channel), and count the number of registered events per channel. When such information is graphically rendered (for a given counting time / accumulation time), it yields a measured spectrum as illustrated in Figure 2, for example (discussed in more detail later);
- After a spectrum has been obtained in this way for said location, one can move on to a subsequent location on the sample 410, by causing appropriate relative motion of the sample holder 408 and the beam 404. In this way, one accrues a matrix of X-ray spectra for a (non-depicted) set S of the locations on the sample 410.

As explained above, when the input beam 404 impinges on a given location of the sample 410, there will be a relation between the X-ray flux emanating from said location - and intercepted by the detector 420 - and (for example) the beam current employed in the beam 404: if the beam current is too high, the X-ray flux may be so high as to cause significant pile-up behaviour at the detector 420, whereas if the beam current is too low, the detector 420 will demonstrate a non-optimal signal-to-noise ratio. This problem is exacerbated in that, for a general sample 410 and a given beam current of the input beam 404, the X-ray brightness will typically vary as a function of location on the sample 410, due to the generally varying material composition of the sample. Ideally, the selected beam current in the beam 404 will be just low enough to prevent significant pile-up behaviour at the brightest X-ray location on the sample 410, thus ensuring the best attainable signal-to-noise ratio for the whole sample.

According to the current invention, such an optimal beam current value (I*) can be derived as follows:
- Prior to acquiring a "proper" matrix of X-ray spectra (using a relatively long counting time of the detector 420), one selects a set T of positions on the sample 410, whereby T is as least a subset of S.
- For each position in T:
   ■ The focused input beam 404 of charged particles is directed onto that position;
   ■ One performs a measurement operation that comprises at least one of the following procedures:
      □ Using detector 420 to accrue an X-ray spectrum for said position during a relatively short counting time;
      □ Using detector 100 to detect electrons in said flux and determine an electron brightness for said position.
- One then analyzes the data obtained in said measurement operation and processes it to calculate a value for I*, e.g. by referring to a look-up table as alluded to above.

### Embodiment 2

Figure 2 shows an EDX spectrum accrued from a metallurgical sample. The spectrum is a plot of measured Intensity along the ordinate (proportional to photon counts per channel) versus photon Energy in keV along the abscissa (determined by the channel into which a photon is sorted by the processing circuitry associated with the detector). The spectrum shows a number of distinct peaks that are superimposed upon a lower background.

The positions and relative heights of particular sets of these peaks are characteristic of the material generating them. For example, Vanadium (V) generates a trio of (distinguishable) peaks in the depicted spectrum, at energies of approx. 0.5, 4.9 and 5.4 keV. Chromium (Cr), on the other hand, is responsible for peaks at about 0.5, 5.4 and 5.95 keV (two of which apparently coincide with corresponding peaks of Vanadium at the employed energy resolution along the horizontal axis).

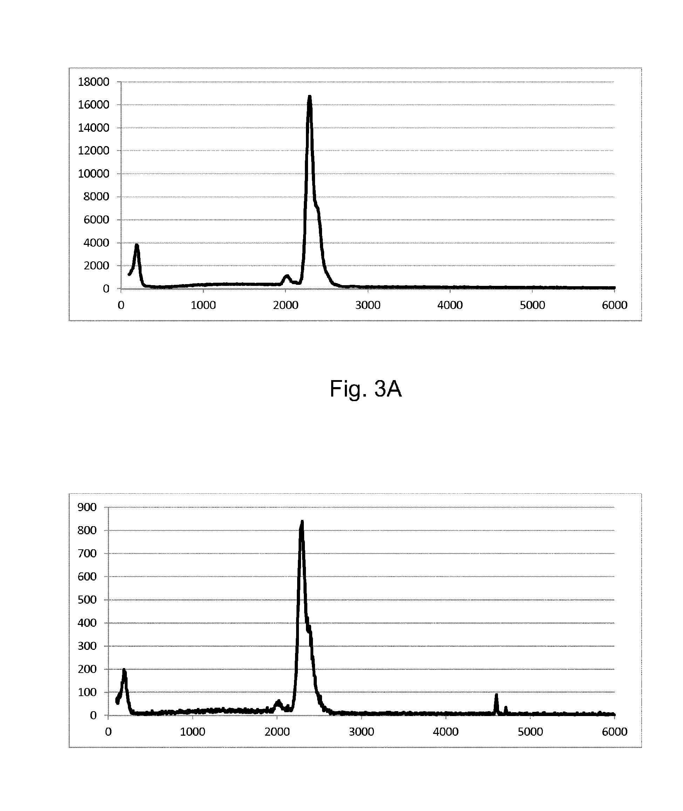

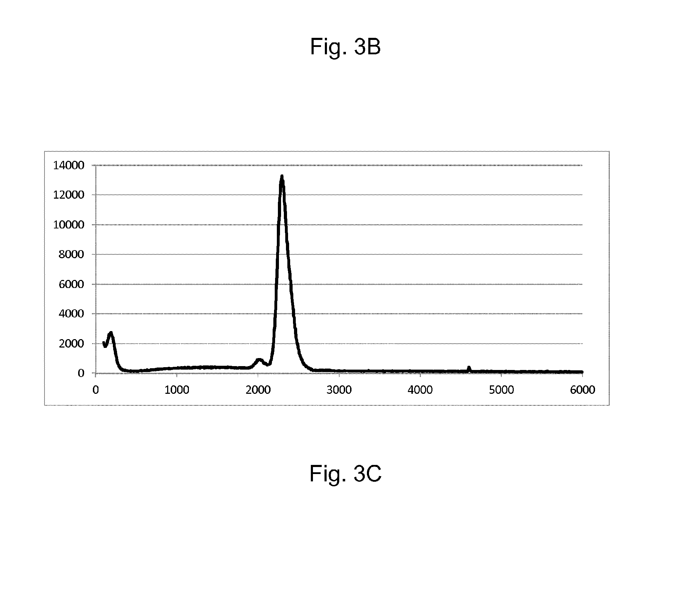

Moving on now to Figure 3, this shows a collection of three EDX spectra for another sample, accrued at a location comprising a relatively high concentration of Molybdenum (Mo). The ordinate shows counts per channel, whereas the abscissa shows energy in eV. In the depicted energy range, Mo ideally exhibits two characteristic peaks - the so-called Lα and Lβ1 peaks. In more detail, the following is depicted:
- Figure 3A: This spectrum was accrued using a relatively low input beam current, relatively long counting (accumulation) time, and a relatively long registration time (low count rate). It is a relatively "ideal" spectrum in which the Lα feature is clearly visible as a tall peak at about 2.29 keV, and the Lβ1 feature manifests itself as a lower "shoulder" at about 2.37 keV. However, the spectrum's good detail and resolution come at the expense of throughput.
- Figure 3B: In an effort to increase throughput, this spectrum was accrued using a higher input beam current and a shorter counting (accumulation) time. Compared to Figure 3A, there is a drastically lower number of counts, and the spectrum is correspondingly noisier. The Lα and Lβ1 features are still visible, but the increased noise levels make the Lβ1 shoulder more difficult to discern. The reduced quality of the spectrum is due to a large incidence of pile-ups, most of which were discarded by the processing circuitry of the employed detector, but a small number of which "got through" (e.g. due to exactly simultaneous arrival of two photons), with small false peaks at about 4.6 and 4.7 keV as a consequence.
- Figure 3C: This spectrum was accrued using a shorter registration time, so as to decrease the incidence of pile-ups. As a result, counts are increased and noise is decreased. However, as already explained above, a shorter registration time brings an attendant decrease in energy resolution. Consequently, the Lβ1 shoulder is now no longer (clearly) visible.

In this example, it is clear that, at least at the Mo-rich location in question, one can better use the spectrum of Figure 3A than that of Figures 3B or 3C. Consequently, at this Mo-rich location, a relatively low input beam current gives most satisfactory results. On the other hand, at another location in which a different material (concentration) has the overhand, a different beam current value might give optimum results. In the case of a typical sample comprising a mosaic of different material concentrations, generally optimal results are obtained if the employed beam current has the maximum possible value that will not cause significant pile-up behavior at any investigated sample location. Such a beam current value can be pre-calculated using the method according to the current invention, on the basis of a relatively quick "pre-scan" as elucidated above.

## Claims

1. A method of automatically examining a sample using a charged-particle microscope, comprising the following steps:
- Providing the sample on a sample holder;
- Selecting a set S of locations on the sample;
- For each location in S:
■ Directing a focused input beam of charged particles onto that location, thereby producing an interaction that causes a flux of emitted radiation to emanate from that location;
■ Detecting X-rays in said flux using a multi-channel photon-counting detector, thus accruing an X-ray spectrum for said location during a given counting time,
thereby acquiring a matrix of X-ray spectra for the set S,
**characterized by** the following steps:
- Prior to acquiring said matrix of X-ray spectra, selecting a set T of positions on the sample, whereby T is as least a subset of S, and, for each position in T:
■ Directing said focused input beam of charged particles onto that position;
■ Performing a measurement operation that comprises at least one of the following procedures:
□ Accruing an X-ray spectrum for said position during a test counting time shorter than said given counting time;
□ Detecting electrons in said flux using an electron detector and determining an electron brightness for said position;
- Analyzing the data obtained in said measurement operations and processing it to calculate a value of an input beam parameter selected from the group comprising beam current and beam energy;
- Using said calculated input beam parameter value in acquiring said matrix of X-ray spectra for the set S.

2. A method as claimed in claim 1, wherein said detected electrons in said flux are backscattered electrons.

3. A method as claimed in claim 1 or 2, wherein said step of analyzing the data obtained in said measurement operations and processing it to calculate a value of an input beam parameter comprises making reference to a table of data compiled from previous examinations of one or more samples.

4. A method as claimed in any preceding claim, wherein said beam parameter is chosen from the group comprising beam current and beam energy.

5. A charged-particle microscope constructed and arranged to perform a method as claimed in any of the claims 1-4.
